# EUROPÄISCHE PATENTANMELDUNG

(11) **EP 2 302 798 A1**
(43) Veröffentlichungstag der Anmeldung: **30.03.2011**
(21) Anmeldenummer: 09171101.0
(22) Anmeldetag: 23.09.2009
(51) Int. Cl.: H03K 17/691

(54) **Steuerung für ein Halbleiterbauelement**

(71) Anmelder: ABB Schweiz AG, 5400 Baden (CH)
(72) Erfinder: Weber, Florian, 5417 Untersiggenthal (CH)
(74) Vertreter: Berner, Thomas

(57) **Zusammenfassung**

Ein Steuersignal einer Sekundärsteuerung 12 einer Steuerung 10 zur Anwendung im Bereich der Leistungselektronik wird über die gleiche Leitung 20 übertragen, die zur Energieversorgung einer Primärsteuerung 14a durch die Sekundärsteuerung 12 dient. Eine vorhandene galvanische Entkopplung 24a der Leitung 20 kann auch zur galvanischen Entkopplung der Signalübertragung verwendet werden.

## Beschreibung

### Technisches Gebiet

Die Erfindung betrifft das Feld der Steuerung von Halbleiterbauelementen zur Anwendung im Bereich der Leistungselektronik. Insbesondere betrifft die Erfindung eine Sekundärsteuerung für ein Halbleiterbauelement zur Stromversorgung einer Primärsteuerung; die Primärsteuerung für das Halbleiterbauelement; eine Steuerung für das Halbleiterbauelement, die die Sekundärsteuerung und die Primärsteuerung umfasst; die Verwendung einer galvanisch entkoppelten Stromleitung zwischen einer Primärsteuerung und einer Sekundärsteuerung und ein Verfahren zum Steuern des Halbleiterbauelements.

### Stand der Technik

In derzeit verwendeten Anordnungen zur Steuerung von Leistungshalbleiterbauelementen werden in der Regel eine Primärsteuerung zur direkten Steuerung des Leistungshalbleiters und eine galvanisch entkoppelte Sekundärsteuerung zur Energieversorgung der Primärsteuerung und zum Steuern der Primärsteuerung bzw. indirekten Steuern des Leistungshalbleiters verwendet. In der Regel befindet sich die Sekundärsteuerung auf Erd- oder Neutralpotential und die Primärsteuerung, die an den Halbleiter gekoppelt ist, liegt häufig auf dem Halbleiterpotentials bzw. bewegt sich mit diesem mit. Dies hat beispielsweise den Vorteil, dass die Primärsteuerung gegenüber dem Halbleiter nicht besonders stark isoliert werden muss. Allerdings kann es notwendig sein, einerseits über eine elektrisch bzw. galvanisch isolierte Schnittstelle Steuersignale zur Steuerung der Primärsteuerung (beispielsweise um den Halbleiter an- und auszuschalten) zu übertragen und andererseits auf eine isolierte Art und Weise Energie von der Sekundärsteuerung zur Primärsteuerung zu übertragen.

Die Steuerung bzw. die Signalübertragung kann über ein faseroptisches Kabel erfolgen, die eine Isolierung der Primärsteuerung von der Sekundärsteuerung sicherstellt. Die Energieübertragung, die zur Versorgung der Primärsteuerung verwendet wird, kann durch einen Transformator umgesetzt werden, der die Primärsteuerung gegenüber Hochspannung isoliert.

### Darstellung der Erfindung

Aufgabe der Erfindung ist es, ein einfach aufgebautes Halbleitersystem zur Anwendung im Bereich der Leistungselektronik bereitzustellen, bei dem sich die Komponenten auf unterschiedlichen Potentialen befinden können.

Diese Aufgabe wird durch den Gegenstand der unabhängigen Ansprüche gelöst. Weitere Ausführungsformen der Erfindung ergeben sich aus den abhängigen Ansprüchen.

Ein Aspekt der Erfindung ist eine Sekundärsteuerung für ein Halbleiterbauelement zur Anwendung im Bereich der Leistungselektronik.

Gemäß einer Ausführungsform der Erfindung umfasst die Sekundärsteuerung eine Stromleitung zur Energieversorgung einer Primärsteuerung des Halbleiterbauelements mit Strom, eine erste Steuerlogik zur Steuerung der Primärsteuerung, wobei die Stromleitung von der Primärsteuerung galvanisch entkoppelt ist, wobei die erste Steuerlogik dazu ausgeführt ist, ein Steuersignal über die Stromleitung an die Primärsteuerung zu senden.

Ein Steuersignal, beispielsweise ein Signal, dass das Halbleiterbauelement ein- oder ausgeschaltet werden soll, wird damit über die gleiche Leitung übertragen, die zur Energieversorgung der Primärsteuerung dient. Eine vorhandene galvanische Entkopplung der Leitung kann auch zur galvanischen Entkopplung der Signalübertragung verwendet werden.

Zur Übertragung von Steuersignalen ist keine faseroptische Verbindung notwendig, wobei aber nicht ausgeschlossen werden soll, dass nicht weitere faseroptische Verbindungen zur Übertragung von anderen Signalen bei der hier beschriebenen Steuerung vorhanden sein können. Durch den Verzicht auf faseroptische Verbindungen kann der Verkabelungsaufwand und die Anzahl der Kabel vermindert werden.

Das Halbleiterbauelement zur Anwendung im Bereich der Leistungselektronik bzw. ein Leistungshalbleiterbauelement kann einen Halbleiter umfassen, der dazu ausgeführt ist, Ströme über 100 A und/oder Spannungen über 300 V zu verarbeiten bzw. zu schalten. Beispielsweise kann das Halbleiterbauelement einen Bipolartransistor mit isolierter Gateelektrode (IGBT), einen Unipolartransistor mit isolierter Gateelektrode (MOSFET), einen Thyristor oder eine Diode umfassen.

Die Stromleitung kann eine galvanische Entkopplung umfassen, beispielsweise in der Form eines Transformators. In einem einfachsten Fall umfasst die Stromleitung lediglich zwei einzelne Leiter, bzw., falls die Stromleitung einen Transformator umfasst, zwei einzelne Leiter von der Sekundärsteuerung zum Trafo und zwei weitere einzelne Leiter vom Transformator zur Primärsteuerung.

Unter einer Stromleitung ist beispielsweise eine allgemeine Stromzuführung zu verstehen, die zum Beispiel eine drahtgebundene Stromleitung oder mehrere drahtgebundene Stromleitungen umfassen kann und in der auch galvanische Isolationselemente zur galvanischen Entkopplung der Stromleitung von der Primärsteuerung zur Sekundärsteuerung enthalten sein können. Eine Stromleitung kann jegliche Vorrichtung sein, die zur Übertragung von elektrischer Energie ausgeführt ist.

Eine galvanische Entkopplung der Sekundärsteuerung von der Primärsteuerung kann dazu ausgeführt sein, dass Strom von der Sekundärsteuerung zur Primärsteuerung übertragen werden kann und die Primärsteuerung und die Sekundärsteuerung sich auf unterschiedlichen elektrischen Potentialen befinden.

Die galvanische Entkopplung kann dazu ausgeführt sein, dass die Sekundärsteuerung von der Primärsteuerung gegenüber einer Hochspannung von mehr als 300 V isoliert ist. Der Transformator könnte beispielsweise wenigstens zwei Wicklungen umfassen, die jeweils mit der Sekundärsteuerung und der Primärsteuerung verbunden sind, und die gegenüber einander derart isoliert sind, dass sich die beiden Wicklungen mit wenigstens 300 V Potential voneinander unterscheiden können, ohne dass ein Durchschlag auftritt.

Die Sekundärsteuerung umfasst eine erste Steuerlogik und die Primärsteuerung kann eine zweite Steuerlogik umfassen. Die erste Steuerlogik und die zweite Steuerlogik können mit der Stromleitung verbunden sein, wobei die erste Steuerlogik dazu ausgeführt ist, ein Steuersignal über die Stromleitung an die Primärsteuerung, insbesondere die zweite Steuerlogik zu senden oder zu übertragen, und die zweite Steuerlogik dazu ausgeführt ist, das Steuersignal über die Stromleitung zu empfangen.

Insgesamt ist es möglich, die Energieübertragung und die Signalübertragung in eine einfachen Zweileiterverbindung zur kombinieren. Die galvanische Isolierung kann dabei durch die galvanische Isolierung eines Transformers bereitgestellt werden. Dadurch können der Aufwand zum Verkabeln bzw. die Anzahl der Kabel reduziert werden.

Gemäß einer Ausführungsform der Erfindung ist die erste Steuerlogik dazu ausgeführt, in der Stromleitung einen Wechselstrom zur Energieversorgung der Primärsteuerung zu erzeugen. Beispielsweise kann der Wechselstrom ein bipolares Rechtecksignal umfassen, das von der ersten Steuerlogik aus einer Gleichstromquelle erzeugt wird. Das Rechtecksignal kann über einen ersten Stromkreis der Stromleitung an den Transformator gesendet werden, der das Rechtecksignal an einen zweiten Stromkreis der Stromleitung überträgt, der wiederum mit der Primärsteuerung verbunden ist. Die Primärsteuerung und insbesondere die zweite Steuerlogik können den Wechselstrom und insbesondere das bipolare Rechtecksignal gleichrichten und glätten und die mit dem Rechtecksignal bzw. dem Wechselstrom übertragene Energie zur eigenen Energieversorgung verwenden.

Gemäß einer Ausführungsform der Erfindung ist die erste Steuerlogik dazu ausgeführt, einen Strom in der Stromleitung zum Erzeugen des Steuersignals zu modulieren. Unter Modulieren kann dabei verstanden werden, dass dem Strom in der Stromleitung, der beispielsweise ein Gleichstrom oder ein Wechselstrom sein kann, ein weiteres Signal überlagert wird, das zur Informationsübertragung dient. Beispielsweise könnte im Falle von Wechselstrom, die Frequenz des Wechselstroms moduliert werden und damit das Steuersignal mittels Frequenzmodulation übertragen werden.

Gemäß einer Ausführungsform der Erfindung ist die erste Steuerlogik dazu ausgeführt, eine Pulsweitenmodulation durchzuführen, um das Steuersignal zur Steuerung der Primärsteuerung auf dem Wechselstrom aufzumodulieren. Wird kein Steuersignal bzw. kein anderes Signal über die Stromleitung gesendet bzw. übertragen, umfasst der unmodulierte Wechselstrom in der Regel einen alternierenden Stromverlauf, wobei positive Kurvenverläufe jeweils die gleiche Form haben und die negativen Kurvenverläufe jeweils eine spiegelbildliche Form dazu aufweisen. Zum Beispiel kann der unmodulierte Wechselstrom ein bipolares Rechtecksignal sein, wobei die einzelnen Rechteckpulse alle die gleiche Länge aufweisen. Wird ein Signal übertragen, kann die Breite der einzelnen Pulse bzw. der Kurvenverläufe des Wechselstroms moduliert bzw. variiert werden.

Gemäß einer Ausführungsform der Erfindung ist die erste Steuerlogik dazu ausgeführt, ein erstes Steuersignal für eine erste Primärsteuerung und ein zweites Steuersignal für eine zweite Primärsteuerung zu erzeugen und das erste und das zweite Steuersignal über die Stromleitung zu übertragen. Die erste Primärsteuerung kann dafür ausgeführt sein, ein erstes Halbleiterbauelement zu steuern und die zweite Primärsteuerung kann dafür ausgeführt sein, ein zweites Halbleiterbauelement zu steuern. Insgesamt kann die Sekundärsteuerung damit zwei unterschiedliche Steuersignale abgeben, die für zwei unterschiedliche Primärsteuerungen bestimmt sind, die beide an die gleiche Stromleitung angeschlossen sein können. Die Primärsteuerungen können dazu ausgeführt sein, die beiden Steuersignale voneinander zu unterscheiden. Beispielsweise könnte die Sekundärsteuerung ein erstes Steuersignal abgeben, das die erste Primärsteuerung dazu anweist, ein erstes Halbleiterbauelement an- bzw. auszuschalten und ein zweites Steuersignal abzugeben, das die zweite Primärsteuerung dazu veranlasst, das zweite Halbleiterbauelement an- bzw. auszuschalten.

Die Sekundärsteuerung ist damit also geeignet, eine Mehrzahl von Primärsteuerungen zu steuern.

Gemäß einer Ausführungsform der Erfindung umfasst die Sekundärsteuerung weiter einen Transformator, wobei die galvanische Entkopplung durch den Transformator erfolgt. Der Transformator kann zur Energieübertragung und zur galvanischen Entkopplung der Primärsteuerung und der Sekundärsteuerung an die Stromleitung gekoppelt sein. Der Transformator kann eine mit der Sekundärsteuerung verbundene Sekundärwicklung, die beispielsweise mit einem ersten Stromkreis mit der Sekundärsteuerung verbunden ist, und eine mit der Primärsteuerung verbundene Primärwicklung, die beispielsweise über einen zweiten Stromkreis mit der zweiten Steuerlogik der Primärsteuerung verbunden ist, umfassen. Die beiden Wicklungen, das heißt die Primärwicklung und die Sekundärwicklungen können dabei voneinander galvanisch isoliert sein und damit die galvanische Entkopplung der beiden Stromkreise bzw. der Sekundärsteuerung von der Primärsteuerung bewirken. Es ist zu verstehen, dass die Begriffe Primärwicklung und Sekundärwicklung auch umgekehrt verwendet werden können, das heißt, dass die Primärwicklung mit der Sekundärsteuerung und die Sekundärwicklung mit der Primärsteuerung verbunden sein können.

Gemäß einer Ausführungsform der Erfindung umfasst der Transformator eine mit der Sekundärsteuerung verbundene Sekundärwicklung und wenigstens eine erste Primärwicklung und eine zweite Primärwicklung, also wenigstens zwei Primärwicklungen. Die erste Primärwicklung ist mit einer ersten Primärsteuerung verbunden und die zweite Primärwicklung ist mit einer zweiten Primärsteuerung verbunden. Durch diesen Aufbau kann die Sekundärsteuerung wenigstens zwei Primärsteuerungen mit Energie versorgen und an wenigstens zwei Primärsteuerungen Steuersignale über die gleich Stromleitung abgeben. Dazu kann beispielsweise die Sekundärsteuerung über einen ersten Stromkreis ein Wechselstromsignal in der Sekundärwicklung des Transformators erzeugen, die elektromagnetisch mit der ersten Primärwicklung und der zweiten Primärwicklung gekoppelt ist und damit in den beiden Wicklungen einen weiteren Wechselstrom erzeugt, der dann weiter an die erste Primärsteuerung und die zweite Primärsteuerung übertragen werden kann.

Gemäß einer Ausführungsform der Erfindung sind die Sekundärwicklung, die erste Primärwicklung und die zweite Primärwicklung voneinander galvanisch isoliert, bzw. voneinander galvanisch entkoppelt. Somit können sich die Sekundärsteuerung und die beiden Primärsteuerungen jeweils auf unterschiedlichen elektrischen Potentialen befinden. Insbesondere ist auch eine galvanische Entkopplung der ersten Primärsteuerung von der zweiten Primärsteuerung möglich.

Mit einem erweiterten Transformer können verschiedene Primärsteuerungen durch eine Sekundärsteuerung gesteuert werden. Dies kann dadurch möglich werden, dass der Transformator auf Seite der Primärsteuerungen zwei Wicklungen umfasst, die voneinander galvanisch getrennt bzw. isoliert sind. Dadurch kann auch die Synchronisierung optimiert werden und nur von den Streuinduktivitäten zwischen den Wicklungen auf Seite der Primärsteuerung abhängen. Dies kann besonders für eine serielle Verbindung vorteilhaft sein.

Ein weiterer Aspekt der Erfindung ist ein Transformator mit einer Sekundärwicklung und wenigstens einer ersten Primärwicklung und einer zweiten Primärwicklung, wobei die Sekundärwicklung, die erste Primärwicklung und die zweite Primärwicklung voneinander galvanisch isoliert sind.

Gemäß einer Ausführungsform der Erfindung umfasst das Halbleiterbauelement einen Hochleistungsschalter. Ein derartiger Hochleistungsschalter kann beispielsweise ein IGBT oder ein Thyristor sein. Die Sekundärsteuerung kann beispielsweise mittels der ersten Steuerlogik ein Steuersignal an die Primärsteuerung, beispielsweise die zweite Steuerlogik der Primärsteuerung senden, dass die Primärsteuerung dazu anweist, den Hochleistungsschalter ein- bzw. auszuschalten. Ein derartiger Hochleistungsschalter kann beispielsweise einen IGBT oder einen Thyristor umfassen.

Ein weiterer Aspekt der Erfindung ist eine Primärsteuerung für ein Halbleiterbauelement zur Anwendung im Bereich der Leistungselektronik.

Gemäß einer Ausführungsform der Erfindung umfasst die Primärsteuerung eine zweite Steuerlogik und eine Stromleitung zur Energieversorgung der zweiten Steuerlogik, wobei die zweite Steuerlogik über die Stromleitung von einer Sekundärsteuerung des Halbleiterbauelements mit Strom versorgbar ist, wobei die Stromleitung von der Sekundärsteuerung galvanisch entkoppelbar ist, wobei die zweite Steuerlogik dazu ausgeführt ist, ein Steuersignal über die Stromleitung von der Sekundärsteuerung zu empfangen. Mit anderen Worten ist die Primärsteuerung das Gegenstück zur Sekundärsteuerung. Die Sekundärsteuerung ist dazu ausgeführt, Energie und ein Steuersignal abzugeben, die Primärsteuerung ist dazu ausgeführt, diese Energie zur eigenen Energieversorgung zu empfangen und das Steuersignal zu empfangen.

Gemäß einer Ausführungsform der Erfindung umfasst die Primärsteuerung einen Gleichrichter in der Stromleitung zum Gleichrichten eines bipolaren Wechselstroms. Beispielsweise kann die Sekundärsteuerung einen Wechselstrom abgeben, der dann über einen Transformator galvanisch entkoppelt zur Primärsteuerung übertragen wird. Die Primärsteuerung wiederum kann den Wechselstrom dann zu einem gleichgerichteten Strom gleichrichten, der dann eventuell geglättet, beispielsweise mittels eines Speicherkondensators, zur Energieversorgung der Primärsteuerung und insbesondere der zweiten Steuerlogik verwendet werden kann. Wird der Strom pulsweitenmoduliert, beispielsweise weil die Sekundärsteuerung gleichzeitig neben der Energie ein Steuersignal überträgt, entsteht durch die Gleichrichtung ein gleichgerichteter (monopolarer) puslweitenmodulierter Strom, aus dem das Steuersignal, beispielsweise durch die zweite Steuerlogik, extrahiert werden kann.

Gemäß einer Ausführungsform der Erfindung ist die zweite Steuerlogik dazu ausgeführt, eine Modulation eines Stroms in der Stromleitung in ein Steuersignal umzuwandeln, d. h. zu demodulieren. Der Strom in der Stromleitung kann beispielsweise frequenz-, phasen- oder auch pulsweitenmoduliert sein. Die zweite Steuerlogik kann diese Modulation des Stroms in das Steuersignal umwandeln.

Ein weiterer Aspekt der Erfindung ist eine Steuerung für ein Halbleiterbauelement.

Gemäß einer Ausführungsform der Erfindung umfasst die Steuerung eine Sekundärsteuerung, so wie sie obenstehend und nachstehend beschrieben ist.

Gemäß einer Ausführungsform der Erfindung umfasst die Steuerung eine Primärsteuerung, so wie sie obenstehend und nachstehend beschrieben ist.

Gemäß einer Ausführungsform der Erfindung umfasst die Steuerung weiter eine galvanische Entkopplung in der Stromleitung zum galvanischen Entkoppeln der Primärsteuerung von der Sekundärsteuerung.

Ein weiterer Aspekt der Erfindung ist die Verwendung einer galvanisch entkoppelten Stromleitung zwischen einer Primärsteuerung und einer Sekundärsteuerung eines Leistungshalbleiterbauelements zur Stromversorgung der Primärsteuerung als eine Signalleitung. Insbesondere, gemäß einer Ausführungsform der Erfindung, wird dabei ein Steuersignal von der Sekundärsteuerung zu der Primärsteuerung übertragen.

Ein weiterer Aspekt der Erfindung betrifft ein Verfahren zum Steuern eines Halbleiterbauelements.

Gemäß einer Ausführungsform der Erfindung umfasst das Verfahren die Schritte: Versorgen einer Primärsteuerung des Halbleiterbauelements mit Strom von einer Sekundärsteuerung über eine galvanisch entkoppelte Stromleitung; Senden bzw. Übertragen eines Steuersignals von der Sekundärsteuerung an die Primärsteuerung über die Stromleitung.

Gemäß einer Ausführungsform der Erfindung umfasst das Verfahren den Schritt von: Empfangen des Steuersignals durch die Primärsteuerung.

Gemäß einer Ausführungsform der Erfindung umfasst das Verfahren den Schritt von: Steuern des Halbleiterbauelements in Reaktion auf den Empfang des Steuersignals.

Gemäß einer Ausführungsform der Erfindung umfasst das Verfahren die Schritte von: Erzeugen eines Wechselstroms in der Stromleitung, beispielsweise eines bipolaren Rechtecksignals; Modulieren, insbesondere Pulsweitenmodulieren des Wechselstroms in der Stromleitung zum Erzeugen eines Steuersignals.

Zur Energieübertragung kann ein bipolares Rechtecksignal verwendet werden. Das bipolare Signal stellt den Transfer mittels eines Transformators sicher, der ein alternierendes Signal (AC) benötigt. Zur Steuerung kann eine Pulsweitenmodulation (PWM) verwendet werden, die in das bipolare Signal integriert ist. Das kombinierte Signal, das mittels des Transformators übertragen wird kann wieder in ein bipolares Rechtecksignal zur Energieversorgung und ein unipolares PWM-Signal zur Signalübertragung getrennt werden.

Gemäß einer Ausführungsform der Erfindung umfasst das Verfahren den Schritt: Übertragen des Stroms und des Steuersignals durch einen Transformator.

Gemäß einer Ausführungsform der Erfindung umfasst das Verfahren den Schritt von: Gleichrichten und Glätten des Stroms in der Stromleitung.

Im Folgenden werden Ausführungsbeispiele der Erfindung mit Bezug auf die beiliegenden Figuren detailliert beschrieben.

### Kurze Beschreibung der Zeichnungen

Fig. 1 zeigt ein schematisches Blockdiagramm einer Steuerung mit einer faseroptischen Signalübertragung.
Fig. 2 zeigt ein schematisches Blockdiagramm eine Steuerung gemäß einem Ausführungsbeispiel der Erfindung.
Fig. 3 zeigt ein Flussdiagramm für ein Verfahren zum Steuern eines Halbleiterbauelements gemäß einem Ausführungsbeispiel der Erfindung.
Fig. 4 zeigt weitere Aspekte des Verfahrens der Fig. 3.

Die in den Figuren verwendeten Bezugszeichen und ihre Bedeutung sind in zusammenfassender Form in der Liste der Bezugszeichen aufgeführt. Grundsätzlich sind identische oder ähnliche Teile mit den gleichen Bezugszeichen versehen.

### Wege zur Ausführung der Erfindung

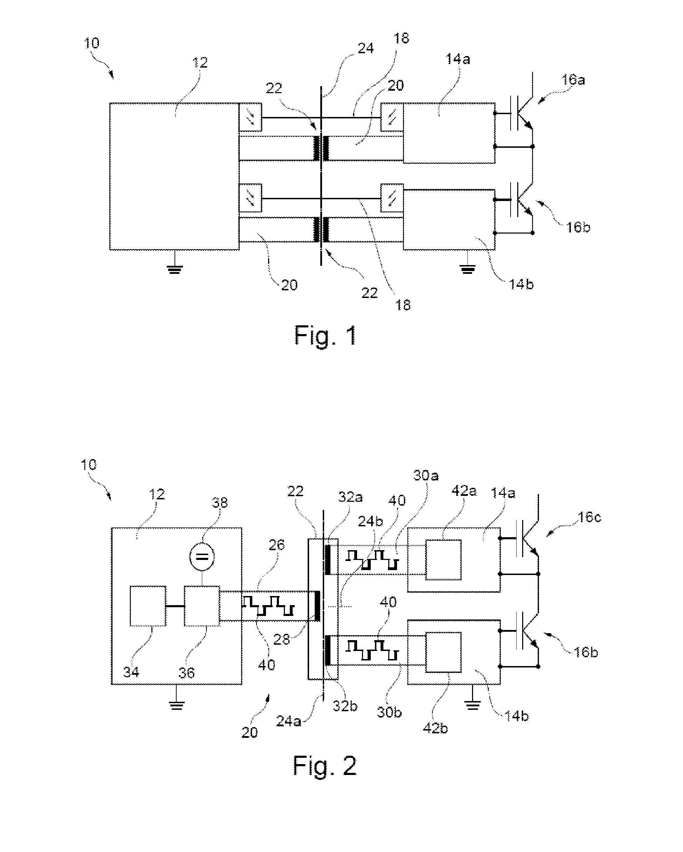

Fig. 1 zeigt schematisch eine Steuerung 10 bzw. Anordnung 10 zur Kommunikation und Energieübertragung, die eine Sekundärsteuerung 12, eine erste Primärsteuerung 14a und eine zweite Primärsteuerung 14b umfasst.

Die Steuerung 10 ist dazu ausgeführt, wenigstens zwei IGBTs 16a, 16b anzusteuern. Dazu steuert die erste Primärsteuerung 14a den ersten IGBT 16a und die zweite

Primärsteuerung 14b den zweiten IGBT 16b. Zwischen den beiden Primärsteuerungen 14a, 14b und der Sekundärsteuerung 12 befinden sich zwei faseroptische Verbindungen 18, über die die Sekundärsteuerung Steuersignale an die erste Primärsteuerung 14a und die zweite Primärsteuerung 14b übertragen kann.

Des Weiteren ist die erste Primärsteuerung 14a und die zweite Primärsteuerung 14b über jeweils eine Stromleitung 20 mit der Sekundärsteuerung verbunden. Über die Stromleitung 20 kann elektrische Energie von der Sekundärsteuerung 12 zu der ersten Primärsteuerung 14a und der zweiten Primärsteuerung 14b übertragen werden.

Die Sekundärsteuerung 12 befindet sich auf Erdpotential bzw. auf dem Neutralpotential des Hochleistungshalbleitersystems, das die beiden Halbleiterbauelemente 16a, 16b umfasst. Die erste Primärsteuerung 14a befindet sich auf dem aktuellen Potential des ersten Halbleiters 16a und die zweite Primärsteuerung 14b befindet sich auf dem aktuellen Potential des zweiten Halbleiters 16b, das sich von dem Potential des ersten Halbleiters 16a erheblich unterscheiden kann. Die beiden Potentiale der Halbleiterbauelemente 16a, 16b bzw. der beiden Primärsteuerungen 14a, 14b können sich voneinander und vom Potential der Sekundärsteuerung 12 um einige 100 V bis einige 1000V unterscheiden.

Um die Sekundärsteuerung 12 von den beiden Primärsteuerungen 14a, 14b zu isolieren, umfassen die beiden Stromleitungen 20 jeweils einen Transformator 22, der eine galvanische Isolierung 24 bereitstellt.

Die erste Primärsteuerung 14a bzw. die zweite Primärsteuerung 14b können jeweils eine sogenannte Gateeinheit 14a, 14b sein, die so ausgeführt ist, das Gate eines IGBTs 16a, 16b oder Thyristors 16a, 16b zu schalten. Des Weiteren kann die Sekundärsteuerung eine sogenannte obere Steuerung sein, die dazu ausgeführt ist, die beiden Gateeinheiten 16a, 16b mit Energie zu versorgen und die beiden Gateeinheiten mit Steuersignalen anzusteuern.

Fig. 2 zeigt schematisch ein weiteres Ausführungsbeispiel einer Steuerung 10. Das zur Fig. 1 gesagte gilt, insofern keine Abweichungen zum Ausführungsbeispiel der Fig. 1 bestehen, auch für das Ausführungsbeispiel der Fig. 2.

Die Steuerung 10 umfasst eine Sekundärsteuerung 12, die über eine Stromleitung 20 mit einer ersten Primärsteuerung 14a und einer zweiten Primärsteuerung 14b zur Energieversorgung der beiden Primärsteuerungen 14a, 14b verbunden ist. Die beiden Primärsteuerungen 14a und 14b können jeweils wieder ein Hochleistungshalbleiterbauelement, wie etwa einen IGBT 16a, 16b steuern.

Die Sekundärsteuerung 12 ist dazu ausgeführt, ein bipolares Rechtecksignal zu erzeugen und über einen sekundären Stromkreis 26 an einen Transformator 22 zu übertragen. Dazu ist der sekundäre Stromkreis 26 mit einer Sekundärwicklung 28 des Transformators 22 verbunden. Der Transformator 22 umfasst eine erste Primärwicklung 32a, die mit einem ersten primären Stromkreis 30a verbunden ist und eine zweite Primärwicklung 32b, die mit einem zweiten primären Stromkreis 30b verbunden ist. Die Stromleitung 20 umfasst den Transformator 22, sowie den sekundären Stromkreis 26, den erster primären Stromkreis 30a und den zweiten primärer Stromkreis 30b.

Die beiden Wicklungen 32a, 32b bzw. die Stromkreise 30a, 30b sind über eine erste galvanische Isolierung 24a von der Sekundärwicklung 28 bzw. dem sekundären Stromkreis 26 galvanisch getrennt. Darüber hinaus sind die beiden Primärwicklungen 32a, 32b voneinander durch eine weitere galvanische Isolierung 24b voneinander getrennt. Insgesamt können sich die drei Ausgänge des Transformators bzw. die drei verschiedenen Stromkreise des Transformators 22 auf unterschiedlichen Potentialen befinden. Die erste Primärwicklung 32a und die Sekundärwicklung 28 sowie die zweite Primärwicklung 32b sowie die Sekundärwicklung 28 sind elektromagnetisch miteinander gekoppelt. Daher ist der Transformator 22 dazu geeignet, das bipolare Rechtecksignal im sekundären Stromkreis 26 über die Sekundärwicklung 28 an die beiden Primärwicklungen 32a und 32b und somit in den ersten primären Stromkreis 30a und den zweiten primären Stromkreis 30b zu übertragen.

Der erste primäre Stromkreis 30a ist mit der ersten Primärsteuerung 14a verbunden und der zweite primäre Stromkreis 30b ist mit der zweiten Primärsteuerung 14b verbunden. Die beiden Primärsteuerungen 14a und 14b sind dazu ausgeführt, aus dem vom Transformator 22 übertragenen Rechtecksignal Energie zu gewinnen und zur eigenen Versorgung zu verwenden.

Wie in der Fig. 2 dargestellt, können im einfachsten Fall die Stromkreise 26, 30a, 30b jeweils lediglich zwei Leiter umfassen.

Die Sekundärsteuerung 12 umfasst eine erste Steuerlogik 34, beispielsweise in der Form eines integrierten Schaltkreises oder einer Leiterplatte, die dazu ausgeführt ist, einen Wechselstromerzeuger 36 derart anzusteuern, dass ein Gleichstrom, der beispielsweise aus einer Gleichstromquelle 38 stammen kann, in einen Wechselstrom 40, beispielsweise ein bipolares Rechtecksignal 40, umgeformt wird.

Darüber hinaus umfasst die erste Primärsteuerung 14a eine zweite Steuerlogik 42a. Auch die zweite Primärsteuerung 14b weist eine zweite Steuerlogik 42b auf.

Die zweite Steuerlogik 42a der ersten Primärsteuerung 14a ist mit dem ersten primären Stromkreis 30a verbunden und kann aus dem Wechselstrom 40 beispielsweise mittels eines Gleichrichters, einen monopolaren Strom erzeugen, der zum Beispiel in geglätteter Form dann zur Energieversorgung der zweiten Steuerlogik 42a der ersten Primärsteuerung 14a dienen kann. Analoges gilt für die zweite Steuerlogik 42b, die identisch zur Steuerlogik 42a aufgebaut sein kann.

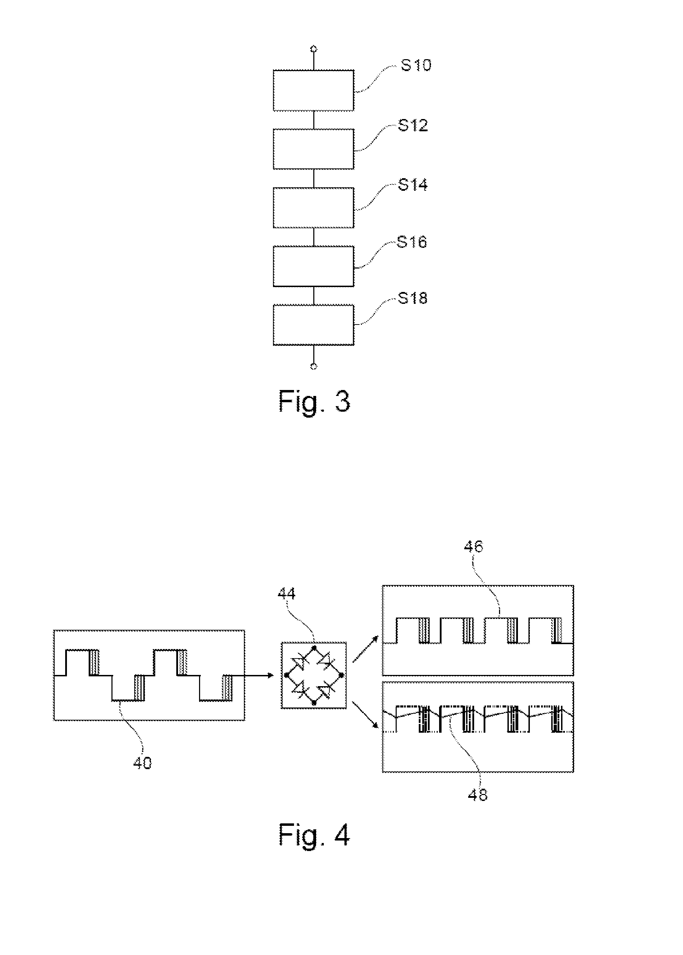

Die Fig. 3 zeigt ein Flussdiagramm für ein Verfahren zur Steuerung von Halbleiterbauelementen 16a, 16b, das von der Steuerung 10 aus der Fig. 2 durchgeführt werden kann.

In einem Schritt S10 wird auf galvanisch entkoppelte Weise Energie von der Sekundärsteuerung 12 zu den beiden Primärsteuerungen 14a, 14b übertragen. Dazu steuert die erste Steuerlogik 34 den Wechselstromerzeuger 36 derart an, dass dieser Gleichstrom, der aus der Gleichstromquelle 38 stammt, in ein bipolares Rechtecksignal 40 umwandelt. Das bipolare Rechtecksignal 40 wird über den sekundären Stromkreis 26 an die Sekundärwicklung 28 des Transformators 22 übertragen, der das Rechtecksignal galvanisch entkoppelt und auf die Primärwicklungen 32a und 32b überträgt. Die erste Primärwicklung 32a ist über den ersten primären Stromkreis 30a mit der zweiten Steuerlogik 42a der ersten Primärsteuerung 14a verbunden. Die zweite Steuerlogik 42a der ersten Primärsteuerung 14a empfängt das vom Transformator 22 übertragene Rechtecksignal, richtet es gleich und glättet es. Das geglättete gleichgerichtete Signal kann dann von der ersten Primärsteuerung 14a zur Energieversorgung verwendet werden. Gleiches bzw. analoges gilt für die zweite Steuerlogik 42b der zweiten Primärsteuerung 14b.

In einem Schritt S12 erzeugt die Sekundärsteuerung 12 ein erstes Steuersignal für die erste Primärsteuerung 14a. Dazu erzeugt die erste Steuerlogik 34 eine Impulsfolge, die kodiert, dass die erste Primärsteuerung 14a den IGBT 16a ein- bzw. ausschalten soll. Diese erste Impulsfolge wird von der Steuerlogik 34 dazu verwendet, den Wechselstromerzeuger 36 derart anzusteuern, dass dieser ein mit der Impulsfolge pulsweitenmoduliertes Wechselstromsignal 40 erzeugt. Das pulsweitenmodulierte Wechselstromsignal 40 wird über den Transformator 22 an die erste Primärsteuerung 14a und die zweite Primärsteuerung 14b übertragen.

In einem Schritt S14 dekodieren bzw. demodulieren die zweite Steuerlogik 42a der ersten Primärsteuerung 14a und die zweite Steuerlogik 42b der zweiten Primärsteuerung 14b das gleichgerichtete pulsweitenmodulierte Signal, um daraus wieder die erste Impulsfolge herzustellen. In Reaktion auf den Empfang der ersten Impulsfolge steuert die erste Primärsteuerung 14a nun den IGBT 16a derart an, so dass diese ein- bzw. ausgeschaltet wird, beispielsweise, indem die erste Primärsteuerung 14a eine Spannung am Gate des IGBT 16a anlegt. Die zweite Steuerlogik 42b der zweiten Primärsteuerung 14b wiederum erkennt, dass die erste Impulsfolge nicht für sie bestimmt ist und verwirft sie deshalb.

Analog dem Schritt S12 kann die erste Steuerlogik 34 der die Sekundärsteuerung 14 in einem Schritt S16 ein zweites Steuersignal für die zweite Primärsteuerung 14a erzeugen, das dem Wechselstrom 40 aufmoduliert wird. In einem dem Schritt S14 analogen Schritt S16 können die beiden zweiten Steuerlogiken 42a, 42b das zweite Steuersignal aus dem pulsweitenmodulierten Signal demodulieren, wobei nun die Steuerlogik 42a das zweite Signal verwirft und die Steuerlogik 42b das Halbleiterbauelement 16b steuert.

Die Primärsteuerungen 14a und 14b sowie deren zweite Steuerlogik 42a, 42b können identisch aufgebaut sein. Die jeweilige zweite Steuerlogik der ersten bzw. zweiten Primärsteuerung 14a, 14b muss lediglich derart konfiguriert sein, dass sie erkennen kann, ob sie die zweite Steuerlogik 42a, 42b der ersten oder der zweiten Primärsteuerung 14a, 14b ist, so dass sie ermitteln kann, welche Steuersignale für sie bestimmt sind.

Fig. 4 zeigt schematisch Aspekte des Modulierens bzw. Demodulierens aus dem in der Fig. 3 dargestellten Verfahren. Wie bereits obenstehend ausgeführt, erzeugt die Sekundärsteuerung 12 ein pulsweitenmoduliertes bipolares Rechtecksignal 40, das über den Transformator 22 übertragen wird. Die zweite Steuerlogik 42a, 42b umfasst einen Gleichrichter 44, der das pulsweitenmodulierte Signal 40, das zur Signal- und Energieübertragung dient, in ein pulsweitenmoduliertes uni- bzw monopolares Signal 46 umwandelt. Das pulsweitenmodulierte Signal 46 kann dann von der zweiten Steuerlogik 42a, 42b zum Demodulieren des Steuersignals bzw. der Signalfolge der Sekundärsteuerung 12 verwendet werden. Des Weiteren kann das unipolare Signal 46 von der zweiten Steuerlogik 42a, 42b noch in ein geglättetes unipolares Signal 48, das nahezu ein Gleichstromsignal sein kann, umgewandelt werden. Das gleichgerichtete Signal 48 kann dann von der Primärsteuerung 14a, 14b zur Energieversorgung verwendet werden.

Mit anderen Worten wird von der zweiten Steuerlogik 42a, 42b das Kombinationssignal 40 in ein Steuersignal 46 und ein Energieversorgungssignal 48 getrennt.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### Bezugszeichenliste

- 10: Steuerung
- 12: Sekundärsteuerung
- 14a: erste Primärsteuerung
- 14b: zweite Primärsteuerung
- 16a: IGBT
- 16b: IGBT
- 18: faseroptische Verbindung
- 20: Stromleitung
- 22: Transformator
- 24: galvanische Isolierung
- 24a: erste galvanische Isolierung
- 24b: zweite galvanische Isolierung
- 26: sekundärer Stromkreis
- 28: Sekundärwicklung
- 30a: erster primärer Stromkreis
- 30b: zweiter primärer Stromkreis
- 32a: erste Primärwicklung
- 32b: zweite Primärwicklung
- 34: erste Steuerlogik
- 36: Wechselstromerzeuger
- 38: Gleichstromquelle
- 40: Wechselstrom
- 42a: zweite Steuerlogik
- 42b: zweite Steuerlogik
- 44: Gleichrichter
- 46: unipolares Signal
- 48: geglättetes Signal

## Patentansprüche

1. Sekundärsteuerung (12) für ein Halbleiterbauelement (16a) zur Anwendung im Bereich der Leistungselektronik, die Sekundärsteuerung umfassend:
eine Stromleitung (20) zur Energieversorgung einer Primärsteuerung (14a) des Halbleiterbauelements (16a) mit Strom,
eine erste Steuerlogik (36) zur Steuerung der Primärsteuerung (14a),
wobei die Stromleitung (20) von der Primärsteuerung (14a) galvanisch entkoppelbar ist,
wobei die erste Steuerlogik (36) dazu ausgeführt ist, ein Steuersignal über die Stromleitung (20) an die Primärsteuerung (14a) zu senden.

2. Sekundärsteuerung (12) nach Anspruch 1, weiter umfassend:
wobei die erste Steuerlogik (36) dazu ausgeführt ist, in der Stromleitung einen Wechselstrom (40) zur Energieversorgung der Primärsteuerung (14a) zu erzeugen.

3. Sekundärsteuerung (12) nach Anspruch 1 oder 2,
wobei die erste Steuerlogik (36) dazu ausgeführt ist, einen Strom in der Stromleitung (20) zur Erzeugung des Steuersignals zu modulieren.

4. Sekundärsteuerung (12) nach Anspruch 3,
wobei die erste Steuerlogik (36) dazu ausgeführt ist, eine Pulsweitenmodulation durchzuführen, um das Steuersignal zur Steuerung der Primärsteuerung (14a) auf den Wechselstrom (40) aufzumodulieren.

5. Sekundärsteuerung (12) nach einem der vorhergehenden Ansprüche,
wobei die erste Steuerlogik (36) dazu ausgeführt ist, ein erstes Steuersignal für eine erste Primärsteuerung (14a) und ein zweites Steuersignal für eine zweite Primärsteuerung (14b) zu erzeugen und das erste und das zweite Steuersignal über die Stromleitung (20) zu übertragen.

6. Sekundärsteuerung (12) nach einem der vorhergehenden Ansprüche, weiter umfassend:
einen Transformator (22),
wobei die galvanische Entkopplung (24) durch den Transformator (22) erfolgt.

7. Sekundärsteuerung (12) nach Anspruch 6,
wobei der Transformator (22) eine mit der Sekundärsteuerung (12) verbundene Sekundärwicklung (28) und wenigstens eine erste Primärwicklung (32a) und eine zweite Primärwicklung (32b) umfasst,
wobei die erste Primärwicklung (32a) mit einer ersten Primärsteuerung (14a) verbunden ist,
wobei die zweite Primärwicklung (32b) mit einer zweiten Primärsteuerung (14b) verbunden ist,
wobei die Sekundärwicklung (28), die erste Primärwicklung (32a) und die zweite Primärwicklung (32b) voneinander galvanisch isoliert sind.

8. Sekundärsteuerung (12) nach einem der vorhergehenden Ansprüche,
wobei das Halbleiterbauelement (16a) einen Hochleistungsschalter umfasst.

9. Primärsteuerung (14a) für ein Halbleiterbauelement (16a) zur Anwendung im Bereich der Leistungselektronik, die Primärsteuerung (14a) umfassend:
eine zweite Steuerlogik (42a),
eine Stromleitung (20) zur Energieversorgung der zweiten Steuerlogik (42a),
wobei die zweite Steuerlogik (42a) über die Stromleitung (20) von einer Sekundärsteuerung (12) des Halbleiterbauelements (16a) mit Strom versorgbar ist,
wobei die Stromleitung (20) von der Sekundärsteuerung (12) galvanisch entkoppelbar ist,
wobei die zweite Steuerlogik (42a) dazu ausgeführt ist, ein Steuersignal über die Stromleitung (20) von der Sekundärsteuerung (12) zu empfangen.

10. Primärsteuerung (14a) nach Anspruch 9, weiter umfassend:
einen Gleichrichter (44) in der Stromleitung (20) zum Gleichrichten eines bipolaren Wechselstroms (40).

11. Primärsteuerung (14a) nach Anspruch 9 oder 10,
wobei die zweite Steuerlogik (42a) dazu ausgeführt ist, eine Modulation eines Stroms in der Stromleitung (20) in ein Steuersignal umzuwandeln.

12. Steuerung (10) für ein Halbleiterbauelement (16a), umfassend:
eine Sekundärsteuerung (12) nach einem der Ansprüche 1 bis 8,
eine Primärsteuerung (14a) nach einem der Ansprüche 9 bis 11,
eine galvanischen Entkopplung (24a) in der Stromleitung (20) zum galvanischen Entkoppeln der Primärsteuerung (14a) von der Sekundärsteuerung (12).

13. Verwendung einer galvanisch entkoppelten Stromleitung (20) zwischen einer Primärsteuerung (14a) und einer Sekundärsteuerung (12) eines Leistungshalbleiterbauelements (16a) zur Stromversorgung der Primärsteuerung (14a) als eine Signalleitung.

14. Verfahren zum Steuern eines Halbleiterbauelements (16a), das Verfahren umfassend die Schritte:
Versorgen einer Primärsteuerung (14a) des Halbleiterbauelements (16a) mit Strom von einer Sekundärsteuerung (12) über eine galvanisch entkoppelte Stromleitung (20);
Übertragen eines Steuersignals von der Sekundärsteuerung (12) an die Primärsteuerung (14a) über die Stromleitung (20).

15. Verfahren nach Anspruch 14, weiter umfassend die Schritte:
Erzeugen eines Wechselstroms (40) in der Stromleitung (20);
Modulieren des Wechselstroms (40) in der Stromleitung (20) zum Erzeugen eines Steuersignals.
